# EUROPEAN PATENT SPECIFICATION

(11) **EP 3 118 998 B1**
(45) Date of publication and mention of the grant of the patent: **21.06.2017**
(21) Application number: 15176403.2
(22) Date of filing: 13.07.2015
(51) Int. Cl.: H03K 17/95

(54) **PROTECTIVE SLEEVE STRUCTURE FOR PROXIMITY SENSOR**
SCHUTZHÜLLENSTRUKTUR FÜR NÄHERUNGSSENSOR
STRUCTURE DE MANCHON DE PROTECTION POUR CAPTEUR DE PROXIMITÉ

(43) Date of publication of application: 18.01.2017
(73) Proprietor: Hwang, Yaw-Der, Taichung (TW)
(72) Inventor: Hwang, Yaw-Der, Taichung (TW)
(74) Representative: Viering, Jentschura & Partner mbB Patent- und Rechtsanwälte

(56) References cited:
- EP-A1- 2 477 013
- FR-A1- 2 963 683
- US-A- 2 615 081
- US-A- 4 394 190
- US-A- 5 877 626
- US-A1- 2010 212 433

## Description

### FIELD OF THE INVENTION

The present invention relates to a protective sleeve structure for a proximity sensor which stops metal substances attaching in a sensing area of a proximity sensor to avoid triggering the proximity sensor unintentionally.

### BACKGROUND OF THE INVENTION

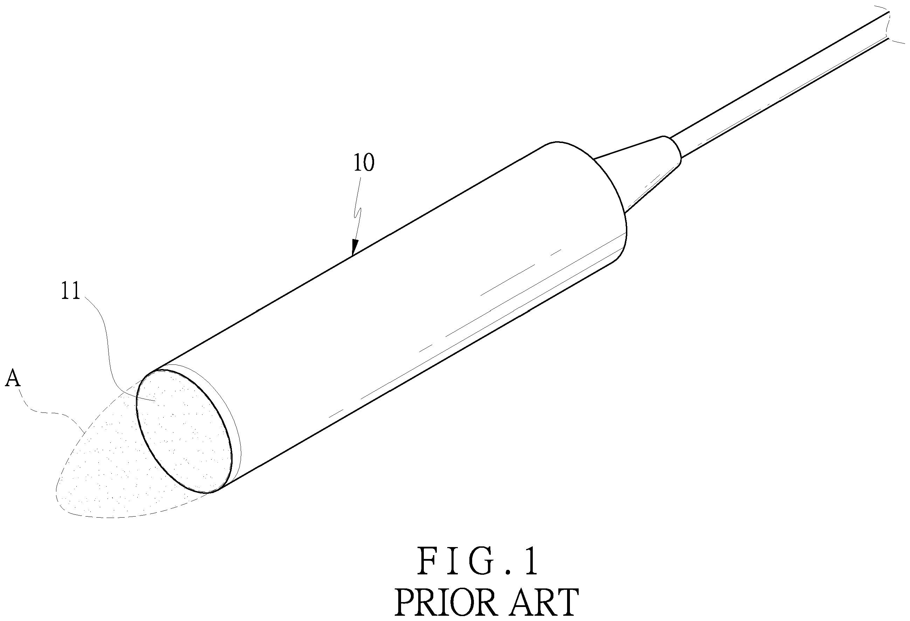

A conventional proximity sensor is applicable for a variety of automated machines, semiconductor equipment or machine tools. The proximity sensor senses an inducing element in non-contacting manner so that data of the inducing element or position information of an operating mechanism is obtained by a controller. Referring to FIG. 1, a conventional inductive proximity sensor 10 contains LC and transistor circuit to produce vibration, such that a sensing area A of a sensing end 11 of the inductive proximity sensor 10 generates high-frequency electromagnetic field. When a magnetic metal object (such as iron or nickel) approaches a plane on a front end of a coil, magnetic vortex in the induction coil changes to transform circuit, thus outputting voltage. Thereafter, the inducing element is sensed if it moves close to or away from the coil.

The inductive proximity sensor 10 senses the inducing element made of magnetic metal material by using electromagnetic effects. Because magnetic lines of the coil are influenced by adjacent objects, when a magnetic attracting object or another magnetic proximity sensor appears the inductive proximity sensor 10, a sensing error occurs to trigger the inductive proximity sensor 10. Taking a machine tool for example, when the machine tool machines a metal workpiece, metal chips attach in the sensing area A of the sensing end 11 of the inductive proximity sensor 10 to cause a sensing error and to trigger the inductive proximity sensor 10 accidently.

The present invention has arisen to mitigate and/or obviate the afore-described disadvantages.

FR 2 963 683 A1 discloses a protective sleeve structure according to the preamble of claim 1. The protective sleeve structure is adapted to an inductive proximity sensor comprising a body made of non-magnetic material, wherein the body includes a fitting portion arranged on a first end thereof to fit with a sensing end of the proximity sensor, wherein an outer surface of the body is located at a non-sensing area of the inductive proximity sensor; the body also includes a passageway defined on a second end thereof and located at a sensing area of the inductive proximity sensor to pass an inducing element through the passageway such that the sensing end of the inductive proximity sensor is triggered.

### SUMMARY OF THE INVENTION

The present invention is directed to a protective sleeve structure according to claim 1. The protective sleeve structure is adapted to an inductive proximity sensor comprising a body made of non-magnetic material, wherein the body includes a fitting portion arranged on a first end thereof to fit with a sensing end of the proximity sensor, wherein an outer surface of the body is located at a non-sensing area of the inductive proximity sensor; the body also includes a passageway defined on a second end thereof and located at a sensing area of the inductive proximity sensor to pass an inducing element through the passageway such that the sensing end of the inductive proximity sensor is triggered. The fitting portion is a recessed hole and matingly fits with the sensing end of the inductive proximity sensor. Hence the inducing element enters into the sensing area of the proximity sensor through the passageway of the body to trigger the proximity sensor, and the outer surface of the body stops metal substances attaching in the sensing area of the proximity sensor to avoid triggering the proximity sensor unintentionally.

Further the body of the protective sleeve structure is simplified and is connected with the sensing end of the proximity sensor easily.

### BRIEF DESCRIPTION OF THE DRAWINGS

FIG. 1 is a perspective view of a conventional proximity sensor.
FIG. 2 is a perspective view showing the assembly of a body of a protective sleeve structure for a proximity sensor according to a first embodiment of the present invention.
FIG. 3 is a perspective view showing the application of the protective sleeve structure for the proximity sensor according to the first embodiment of the present invention.
FIG. 4 is a cross sectional view showing the application of the protective sleeve structure for the proximity sensor according to the first embodiment of the present invention.
FIG. 5-1 is a cross sectional view showing the application of the protective sleeve structure for the proximity sensor according to the first embodiment of the present invention.
FIG. 5-2 is another cross sectional view showing the application of the protective sleeve structure for the proximity sensor according to the first embodiment of the present invention.
FIG. 5-3 is also another cross sectional view showing the application of the protective sleeve structure for the proximity sensor according to the first embodiment of the present invention.
FIG. 6-1 is a cross sectional view showing the application of the protective sleeve structure for the proximity sensor according to a second embodiment of the present invention.
FIG. 6-2 is another cross sectional view showing the application of the protective sleeve structure for the proximity sensor according to the second embodiment of the present invention.
FIG. 6-3 is also another cross sectional view showing the application of the protective sleeve structure for the proximity sensor according to the second embodiment of the present invention.

### DETAILED DESCRIPTION OF THE PREFERRED EMBODIMENTS

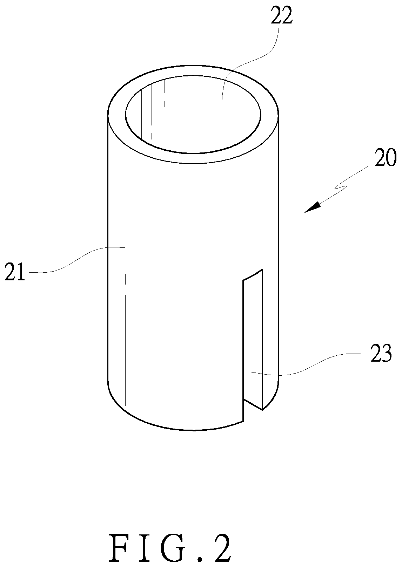

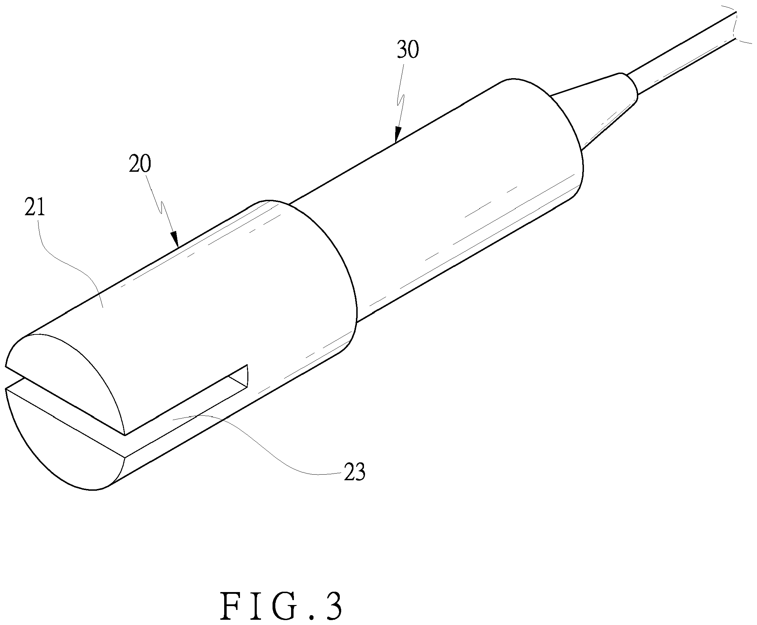

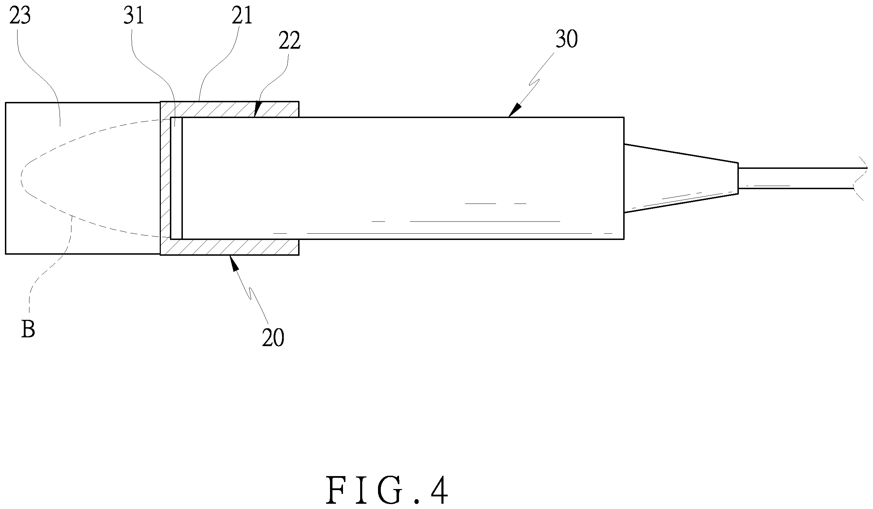

With reference to FIGS. 2 to 4, a protective sleeve structure for a proximity sensor according to a first embodiment of the present invention comprises a body 20 made of non-magnetic material. In this embodiment, the body 20 is injection molded from plastic material or rubber material. The body 20 includes a fitting portion 22 arranged on a first end thereof to fit with a sensing end 31 of a proximity sensor 30, wherein an outer surface 21 of the body 20 is located outside a sensing area B (i.e., non-sensing area) of the proximity sensor 30. In this embodiment, the fitting portion 22 is a recessed hole and its size matches with the sensing end 31 of the proximity sensor 30 so as to matingly fit with the sensing end 31 of the proximity sensor 30, and the body 20 is connected with the sensing end 31 of the proximity sensor 30 easily. The body 20 also includes a passageway 23 defined on a second end thereof and located at the sensing area B of the proximity sensor 30 to pass an inducing element through the passageway 23, such that the inducing element triggers the sensing end 31 of the proximity sensor 30. In this embodiment, the passageway 23 is formed in a slot shape and its width cooperates with a size of the inducing element, wherein a gap between the passageway 23 and the inducing element is minimized. Preferably, the body 20 is simplified greatly, and after the body 20 is connected with the sensing end 31 of the proximity sensor 30, the passageway 23 is located at the sensing area B of the proximity sensor 30, and the outer surface 21 of the body 20 is located at non-sensing area of the proximity sensor 30, such that the protective sleeve structure stops metal substances attaching in the sensing area B of the proximity sensor 30 by using the outer surface 21 of the body 20 to avoid triggering the proximity sensor 30 unintentionally.

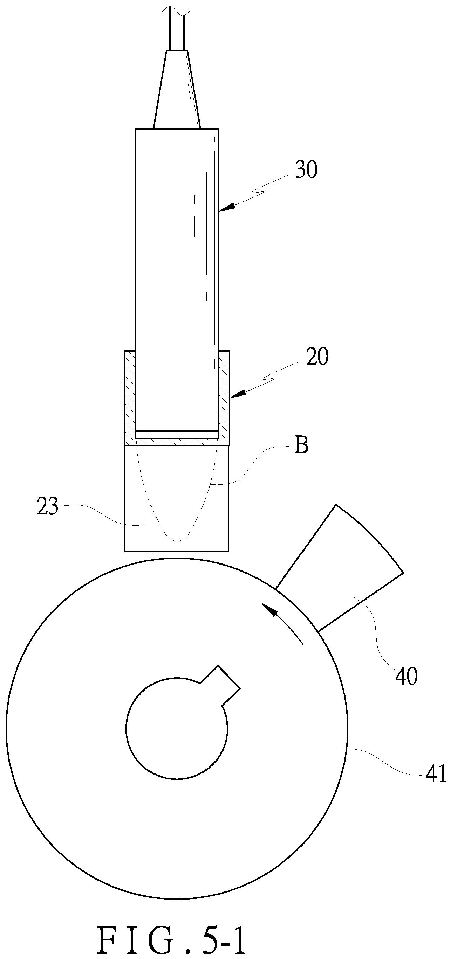

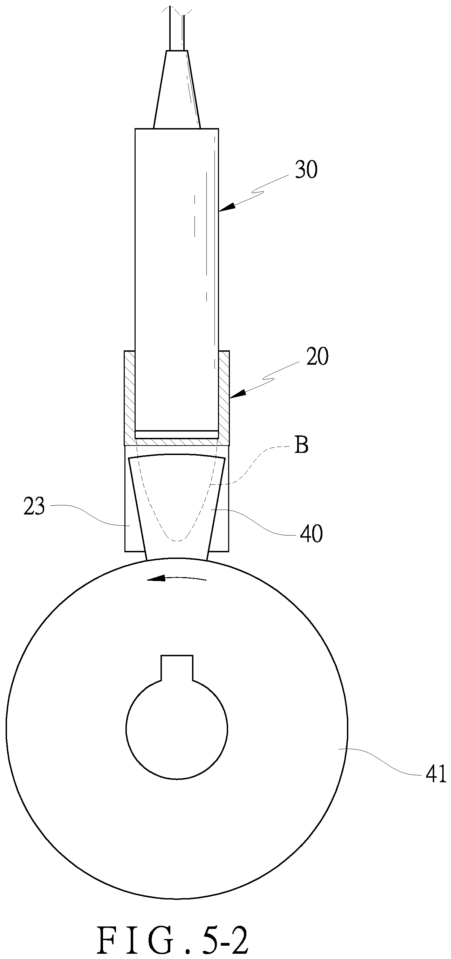

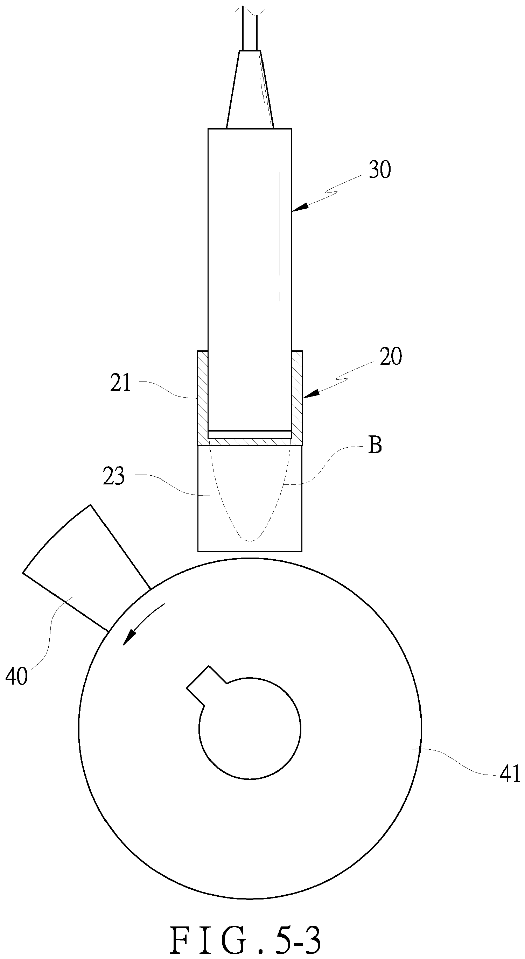

Referring to FIG. 5-1, the inducing element 40 is rotated into the sensing area B of the proximity sensor 30, and the inducing element 40 is made of magnetic metal material and is mounted on an outer peripheral side of a rotating wheel 41. Of course, the inducing element 40 is one piece formed with the rotating wheel 41 so that the inducing element 40 extends outwardly from the outer peripheral of the rotating wheel 41. When the rotating wheel 41 does not rotate, the inducing element 40 is not driven by the rotating wheel 41 to enter into the sensing area B of the proximity sensor 30, so electromagnetic effects in the sensing area B are not changed by the inducing element 40, and the proximity sensor 30 is not triggered. As shown in FIG. 5-2, when the rotating wheel 41 rotates to drive the inducing element 40 to enter into the sensing area B of the proximity sensor 30 through the passageway 23 of the body 20, the inducing element 40 changes the electromagnetic effects in the sensing area B, and the proximity sensor 30 is triggered to transmit a sensing signal to a controller. As illustrated in FIG. 5-3, when the rotating wheel 41 rotates to drive the inducing element 40 to move away from the sensing area B of the proximity sensor 30 via the passageway 23 of the body 20, the electromagnetic effects in the sensing area B recover, and the proximity sensor 30 stops transmitting the sensing signal to the controller. Accordingly, the inducing element 40 enters into the sensing area B of the proximity sensor 30 through the passageway 23 of the body 20 to trigger the proximity sensor 30. Preferably, because the outer surface 21 of the body 20 is located at the non-sensing area of the proximity sensor 30, it protects the sensing area B of the proximity sensor 30 and stops the metal substances attaching in the sensing area B of the proximity sensor 30 to avoid triggering the proximity sensor 30 unintentionally.

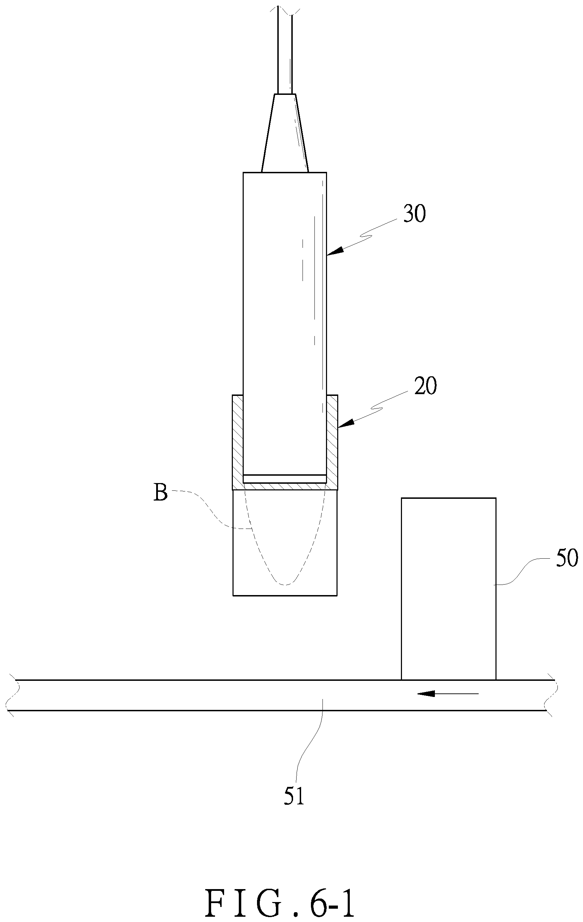

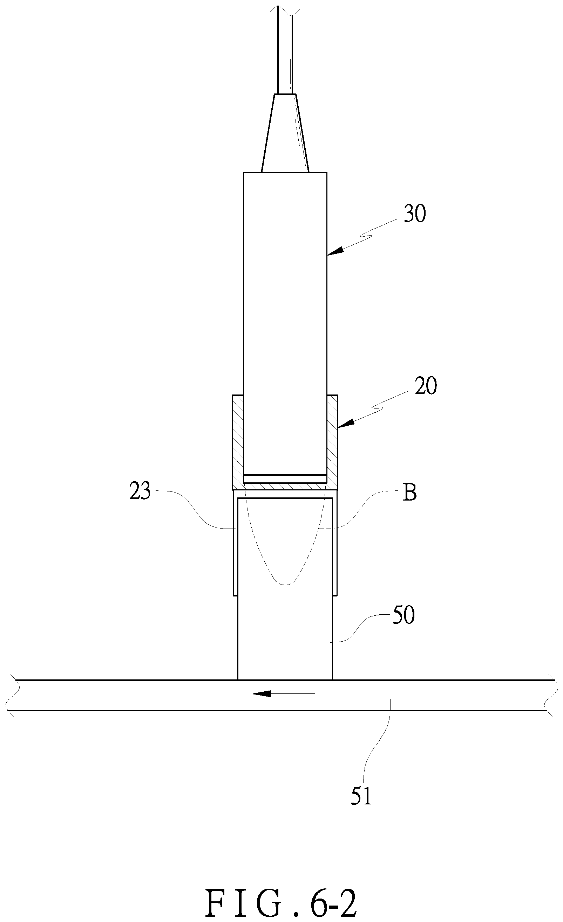

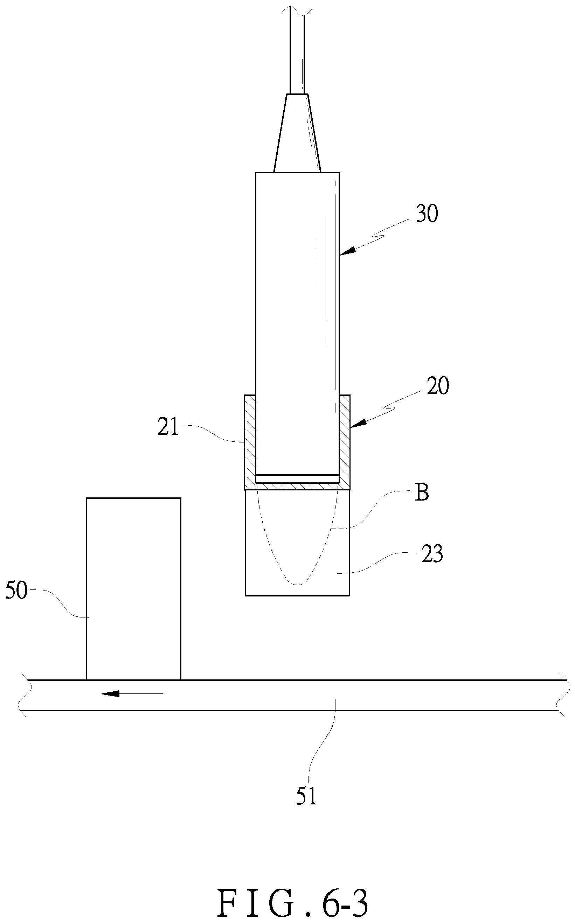

With reference to FIG. 6-1, a difference of a protective sleeve structure for a proximity sensor from that of the first embodiment comprises an inducing element 50 which is linearly moved into the sensing area B of the proximity sensor 30, wherein the inducing element 50 is made of magnetic metal material and is disposed on a platform 51. When the platform 51 does not carry the inducing element 50 to enter into the sensing area B of the proximity sensor 30, electromagnetic effects in the sensing area B are not changed by the inducing element 50, so the proximity sensor 30 is not triggered. Referring to FIG. 6-2, when the platform 51 moves straightly to carry the inducing element 50 to enter into the sensing area B of the proximity sensor 30 through the passageway 23 of the body 20, the inducing element 50 changes the electromagnetic effects in the sensing area B, and the proximity sensor 30 is triggered to transmit a sensing signal to a controller. Referring to FIG. 6-3, when the platform 51 moves straightly to carry the inducing element 50 to move away from the sensing area B of the proximity sensor 30 via the passageway 23 of the body 20, the electromagnetic effects in the sensing area B recover to stop triggering the proximity sensor 30, then the proximity sensor 30 stops transmitting the sensing signal to the controller. Accordingly, the inducing element 50 enters into the sensing area B of the proximity sensor 30 via the accommodation portion 23 of the body 20 to trigger the proximity sensor 30. Preferably, because the outer surface 21 of the body 20 is located at the non-sensing area of the proximity sensor 30, it protects the sensing area B of the proximity sensor 30 and stops the metal substances attaching in the sensing area B of the proximity sensor 30 to avoid triggering the proximity sensor 30 unintentionally.

## Claims

1. A protective sleeve structure adapted to an inductive proximity sensor (30) comprising a body (20) made of non-magnetic material, and the body (20) including:
a fitting portion (22) arranged on a first end thereof to fit with a sensing end (31) of the inductive proximity sensor (30), wherein an outer surface (21) of the body (20) is located at a non-sensing area of the inductive proximity sensor (30);
a passageway (23) defined on a second end thereof and located at a sensing area (B) of the inductive proximity sensor (30) to pass an inducing element (40, 50) through the passageway (23), such that the sensing end (31) of the inductive proximity sensor (30) is triggered,
**characterized in that**
the fitting portion (22) is a recessed hole and matingly fits with the sensing end (31) of the inductive proximity sensor (30).

2. The protective sleeve structure adapted to the inductive proximity sensor (30) as claimed in claim 1, wherein the body (20) is injection molded from plastic material or rubber material.

3. The protective sleeve structure adapted to the inductive proximity sensor (30) as claimed in claim 1, wherein the passageway (23) of the body (20) is formed in a slot shape to pass through the inducing element (40, 50).

## Patentansprüche

1. Schutzhülsenstruktur, die für einen induktiven Näherungssensor (30) ausgebildet ist, der einen Körper (20) aus nichtmagnetischem Material umfasst, der umfasst:
einen an einem ersten Ende desselben angeordneten Befestigungsabschnitt (22), der mit einem Sensorende (31) des induktiven Näherungssensors (30) zusammenpasst, wobei eine Außenfläche (21) des Körpers (20) an einem Nicht-Sensor-Bereich des induktiven Näherungssensors (30) angeordnet ist,
einen an einem zweiten Ende desselben definierten und an einem Sensorbereich (B) des induktiven Näherungssensors (30) angeordneten Durchgang (23) für eine derartige Durchführung eines Induktionselements (40, 50) durch den Durchgang (23), so dass das Sensorende (31) des induktiven Näherungssensors (30) ausgelöst wird,
**dadurch gekennzeichnet, dass**
der Befestigungsabschnitt (22) ein vertieftes Loch ist und mit dem Sensorende (31) des induktiven Näherungssensors (30) zusammenpasst.

2. Schutzhülsenstruktur, die für den induktiven Näherungssensor (30) nach Anspruch 1 ausgebildet ist, wobei der Körper (20) aus Kunststoffmaterial oder Gummimaterial spritzgegossen ist.

3. Schutzhülsenstruktur, die für den induktiven Näherungssensor (30) nach Anspruch 1 ausgebildet ist, wobei der Durchgang (23) des Körpers (20) schlitzförmig zur Durchführung des Induktionselements (40, 50) ausgebildet ist.

## Revendications

1. Structure de manchon de protection adaptée à un capteur de proximité inductif (30) comprenant un corps (20) composé d'un matériau non-magnétique, le corps (20) comprenant :
une partie de raccord (22) prévue sur une première extrémité de celui-ci afin de s'adapter à une extrémité de détection (31) du capteur de proximité inductif (30), une surface extérieure (21) du corps (20) étant située au niveau d'une zone de non-détection du capteur de proximité inductif (30) ;
un passage (23) défini sur une seconde extrémité de celui-ci et situé au niveau d'une zone de détection (B) du capteur de proximité inductif (30) afin de faire passer un élément d'induction (40, 50) dans le passage (23), de sorte que l'extrémité de détection (31) du capteur de proximité inductif (30) soit enclenchée,
**caractérisée en ce que**
la partie de raccord (22) est un orifice renfoncé et s'accouple avec l'extrémité de détection (31) du capteur de proximité inductif (30).

2. Structure de manchon de protection adaptée au capteur de proximité inductif (30) selon la revendication 1, dans laquelle le corps (20) est moulé par injection à partir d'un matériau plastique ou d'un matériau en caoutchouc.

3. Structure de manchon de protection adaptée au capteur de proximité inductif (30) selon la revendication 1, dans laquelle le passage (23) du corps (20) est formé comme une fente afin de passer par l'élément d'induction (40, 50).
